# EUROPEAN PATENT SPECIFICATION

(11) **EP 1 376 602 B1**
(45) Date of publication and mention of the grant of the patent: **17.12.2008**
(21) Application number: 03250442.5
(22) Date of filing: 24.01.2003
(51) Int. Cl.: G11C 11/18

(54) **Magnetic ram using thermo-magnetic spontaneous hall effect and method of writing and reading data using the magnetic ram**
Thermomagnetischer magnetischer RAM-Speicher mit Spontanhalleffekt und Datenschreibe- leseverfahren unter Verwendung eines solchen
Mémoire RAM magnétique utilisant l'effet hall thermomagnétique spontané et méthode d'écriture-lecture de données utilisant une telle mémoire

(30) Priority: 22.06.2002 KR 2002035141
(43) Date of publication of application: 02.01.2004
(73) Proprietor: SAMSUNG ELECTRONICS CO., LTD., Suwon-City, Kyungki-do (KR)
(72) Inventor: Kim, Tae-wan, Anyang-city, Kyungki-do (KR); Kim, Kee-Won, Chungcheongnam-do (KR); Park, Wan-Jun, Gangnam-gu, Seoul (KR); Song, I-Hun, Bundang-gu, Seongnam-city, Kyungki-do (KR); Park, Sang-Jin, Pyeongtaek-city, Kyungki-do (KR)
(74) Representative: Greene, Simon Kenneth

(56) References cited:
- US-A- 5 396 455

## Description

The present invention relates to the field of magnetic RAMs (MRAMs) and methods of writing and reading data using the MRAM, and more particularly, to an MRAM using a thermo-magnetic spontaneous hall effect and a method of writing and reading data using the MRAM.

Grand magnetic resistance (GMR) is derived by a variation in the resistance of a thin film depending on whether two adjacent magnetic layers are magnetized in parallel or counter-parallel, when electrons pass through the two magnetic layers. GMR can be described with reference to spin-dependent scattering.

Even when an insulating film, such as an aluminum oxide film (Al₂O₃), instead of a metallic film is interposed between the two magnetic layers, spin-dependent scattering occurs. The spin-dependent scattering is referred to as tunneling magneto-resistance (TMR).

Conventional MRAMs are non-volatile memory devices using such GMR or TMR. Accordingly, information recorded in the MRAMs is not lost even when power is off, in contrast with DRAMs or SRAMs.

A GMR memory has a spin-valve structure that is composed of a pinned layer having a high coercive force and a free layer having a low coercive force. In the GMR memory, information writing is achieved by changing the spinning direction of the free layer using a produced magnetic field generated by current applied to word lines and bit lines. Information reading is achieved by applying current to the word lines and measuring resistance from the bit lines.

A TMR memory has large magnetic resistance compared to the GMR memory. Accordingly, if the TMR memory is used, a high signal can be obtained, and power consumption can be reduced. However, when the TMR memory is downsized, its operating time is lengthened and noise is increased, since the TMR memory has a great amount of resistance, for example, about 106 Ω µm².

In such conventional MRAMs, when a cell size is reduced to sub-microns or less, coercivity increases, and the thermal security of a cell is degraded. This prevents highly integration.

US 5,396,455 describes a memory cell using the spontaneous Hall effect. In an embodiment, the memory cell is heated to above the curie point to write to the cell.

The present invention provides a magnetic RAM using a spontaneous hall effect according to claim 1.

The present invention thus provides a magnetic RAM (MRAM) using a thermo-magnetic spontaneous hall effect, the MRAM capable of being highly integrated, operating at an ultra-speed, and being simply manufactured to thereby lower the manufacturing costs.

The heating means may be provided over a word line connected to the gate of the MOS transistor.

The heating means is either a nickel chrome (NiCr) alloy layer or a titanium aluminum nitride (TiAlN) layer that is capable of being heated.

Preferably, the memory layer is an amorphous rare earth (RE)-transition metal (TM) layer.

To achieve the second object, the present invention provides a data writing method in which a memory cell having a memory layer to which data is written is selected, and then data is written by heating the memory layer until the memory layer enters into a paramagnetic state.

The present invention also provides a data writing method according to claim 5. And claim 11 specifies a data reading method of the magnetic RAM.

According to the present invention, a magnetic RAM can increase the coercivity caused by highly-integration and improves the thermal security of a cell. The MRAM can operate at an ultra speed because of a small cell resistance. In addition, since the MRAM can be simply manufactured by an existing semiconductor manufacturing process, the manufacturing costs are reduced. Furthermore, since the MRAM writes or reads data using the fact that a spontaneous hall voltage greatly differs according to the magneticization state of a memory layer, it provides a high data sensing margin.

The above objects and advantages of the present invention will become more apparent by describing in detail a preferred embodiment thereof with reference to the , attached drawings in which:
FIG. 1 is a perspective view a unit memory cell for a magnetic RAM (MRAM) using a thermo-magnetic spontaneous hall effect, according to an embodiment of the present invention;
FIGS. 2 and 3 are perspective views for illustrating processes for writing data "1" and "0", respectively, to the unit memory cell of FIG. 1; and
FIGS. 4 and 5 are perspective views for illustrating processes for reading data "1" and "0", respectively, from the unit memory cell of FIG. 1.

A magnetic RAM (MRAM) according to an embodiment of the present invention is a memory layer to which data is written, the memory layer formed of an amorphous rare earths transition metal (hereinafter, referred to as an amorphous RE-TM), which is magnetic. The memory layer uses a spontaneous hall effect, which varies according to the magneticized state of itself. In other words, the hall voltage of the memory layer differs according to the magneticized state of itself. The MRAM according to an embodiment of the present invention uses the spontaneous hall effect in order to write and read data.

The spontaneous hall effect is caused by a spin-orbit interaction, that is, the interaction of free electrons and magnetic moments within a magnetic material, which is a unique characteristic of the magnetic material. The spontaneous hall effect within a magnetic material is significantly greater than a hall effect due to a Lorentz force (hereinafter, referred to as a normal hall effect). In particular, the spontaneous hall effect in the amorphous RE-TM is much greater than the normal hall effect, such that hall voltage due to the normal hall effect in the present invention can be ignored.

The spontaneous hall effect in the memory layer varies according to the magneticized state of the memory layer itself. In other words, the spontaneous hall effect in the memory layer greatly differs depending on whether the memory layer is in a paramagnetic state or in a ferromagnetic state.

If the memory layer is formed of an amorphous RE-TM, when it is heated to a curie point or higher, it enters into a paramagnetic state in which electrons spin in arbitrary directions. Accordingly, spontaneous hall voltage caused by the spontaneous hall effect of the memory layer is reduced. When the memory layer is in the paramagnetic state, if an external magnetic field is applied, the electrons in the memory layer are lined up in a particular direction along the external magnetic field. In other words, the electrons in the memory layer spin in the direction parallel to the direction of the external magnetic field, such that the memory layer enters into a ferromagnetic state. As a result, the spontaneous hall voltage due to the spontaneous hall effect of the memory layer is much higher than when the memory layer is in the paramagnetic state.

The present invention relates to an MRAM for writing or reading data "0" or "1" using the above-described characteristics of the memory layer and a data writing and reading method using the characteristics.

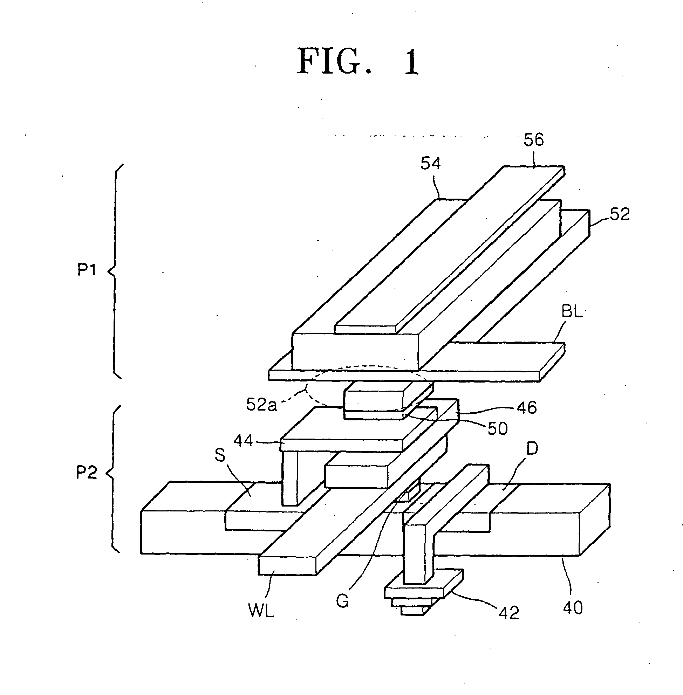

The MRAM according to an embodiment of the present invention is constituted of a plurality of unit cells to which data is written on a bit-by-bit basis. FIG. 1 shows the structure of a unit cell.

Referring to FIG. 1, the unit cell is composed of upper and lower structures P1 and P2. A heating means 50 is interposed between the upper and lower structures P1 and P2.

The lower structure P2 includes a MOS transistor (e.g., an NMOS transistor) and a metal wiring 44 for electrically connecting the impurity region of the MOS transistor, for example, a source region (S), to the heating means 50. The metal wiring 44 can be one of various conductive wirings, for example, an aluminium wiring or a doped polysilicon wiring. In the lower structure P2, reference characters G and D denote a gate and a drain, respectively, of the MOS transistor. Reference character WL denotes a word line connected to the gate G. Reference numerals 40 and 42 denote a substrate on which the MOS transistor is formed and a ground line connected to the drain D, respectively. A first insulating film 46 is interposed between the metal wiring 44 connected to the heating means 50 and the word line WL.

The upper structure P1 includes a memory layer 52, a bit line BL, a second insulating film 54, and a writing line 56. The memory layer 52 has an area 52a to which data "0" or "1" is written, and is parallel to the word line WL. The bit line BL is installed perpendicular to the memory layer 52 and switches data written to the memory layer 52. The second insulating film 54 covers the memory layer 52 and the bit line BL. The writing line 56 is installed on the second insulating film 54 and parallel to the memory layer 52. In order to write data to the area 52a (hereinafter referred to as a data write area) of the memory layer 52, first, the data write area 52a is heated by the heating mean 50 to a given temperature (preferably, a curie point) or higher. Next, the magneticization state of the data write area 52a is determined according to the type of data to be written in order to determine the level of the spontaneous hall voltage of the data write area 52a.

If the data to be written is 1, the data write area 52a enters into a ferromagnetic state in order to obtain high spontaneous hall voltage. However, if the data to be written is 0, the data write area 52a enters into a paramagnetic state in order to obtain low spontaneous hall voltage. Alternatively, if the data to be written is 1, the data write area 52a enters into the paramagnetic state in order to obtain low spontaneous hall voltage. However, if the data to be written is 0, the data write area 52a enters into the ferromagnetic state in order to obtain high spontaneous hall voltage.

When data is written to the data write area 52a of the memory layer 52, the magneticization state of the memory layer 52 is determined by the write line 56. That is, the spontaneous hall voltage of the data write area 52a is also determined by the write line 56.

To be more specific, when data "1" is written to the data write area 52a, a current value to the write line 56 is applied to make the data write area 52a heated to a given temperature or higher enter into the ferromagnetic state. As a result, a magnetic field having an intensity proportional to the current value is formed around the write line 56, and the data write area 52a is placed within the magnetic field. At this time, the heated data write area 52a is in the paramagnetic state. When the magnetic field passes through the data write area 52a in the paramagnetic state, the spinning directions of the electrons of the data write area 52a are lined up parallel to the magnetic field. Consequently, the magneticization state of the data write area 52a is changed from the paramagnetic state to the ferromagnetic state, such that high spontaneous hall voltage is obtained. Accordingly, the data "1" is considered to be written to the data write area 52a.

On the other hand, if data "0" is written to the data write area 52a, current is not applied to the write line 56. Accordingly, no magnetic field is formed around the write line 56. In contrast with the case that data "1" is written, there is no magnetic field to pass through the data write area when data "0" is written. Hence, the paramagnetic state of the data write area 52a when it is heated is maintained, such that the spontaneous hall voltage of the data write area 52a is reduced. From the low spontaneous hall voltage of the data write area 52, it is considered that data "0" has been written to the data write area 52.

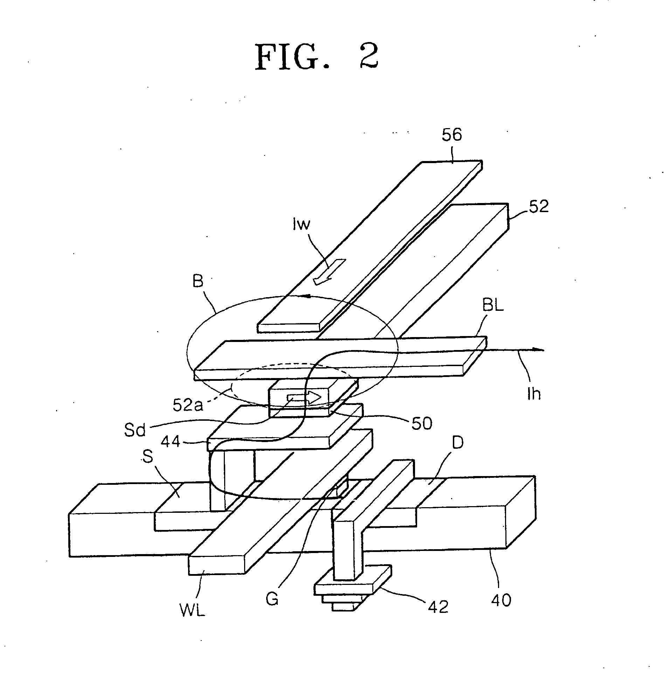

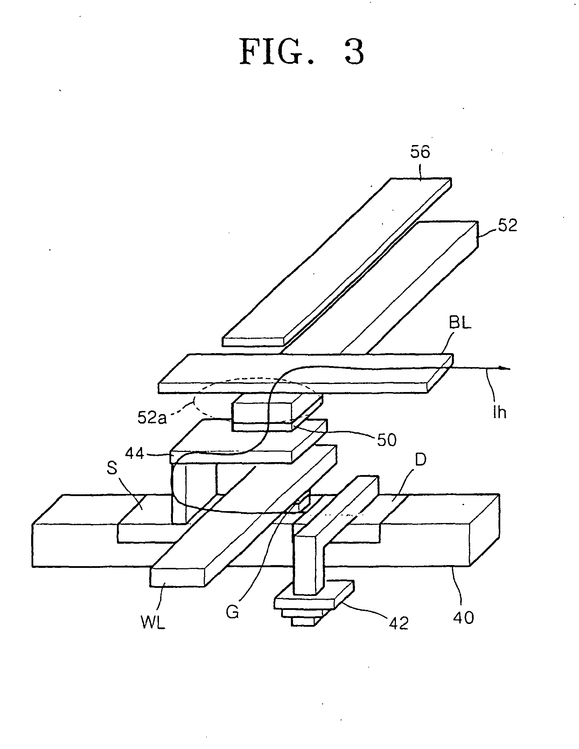

The memory layer 52 is an amorphous RE-TM layer, preferably, a TbCo alloy layer having terbium (Tb) and cobalt (Co). The data write area 52a of the memory layer 52 is placed on the heating means 50 so that they are in contact. The second insulating film 54 is a silicon oxide film but can be other films. The heating means 50 is a material layer, which is heated by current received from the MOS transistor of the lower structure P2 and flowing through the bit line BL in order to heat the data write area 52a of the memory layer 52. preferably, the heating means 50 heats the data write area 52a to a given temperature or higher (for example, 250 ^{■} C if the memory layer 52 is an alloy layer of terbium and cobalt) for a given period of time, more preferably, to the curie point or higher for a short time. For example, the heating means 50 can be a nickel chrome (NiCr) alloy layer or a titanium aluminium nitride (TiAIN) layer.
Hereinafter, a method of writing data to the MRAM will be described with reference to FIGS. 2 and 3. First, a method of writing data "1" will be described with reference to FIG. 2, which shows the flow of current lh applied to heat the heating means 50 of the MRAM of FIG. 1 and a magnetic field B formed in the data write area 52a by current lw applied to the write line 56.

Referring to FIG. 2, current Ih (hereinafter referred to as heating current) is applied from the MOS transistor of the lower structure P2 via the heating means 50 to the bit line BL. Preferably, the heating current Ih is applied to such an extent that the memory layer 52 is heated to at least the Curie point. if the memory layer 52 is a TaCo layer, it is preferable that the heating current lh is applied to such an extent that the memory layer 52 is heated to at least 250 ^{■} C for a given period of time. When the heating means 50 is heated by the heating current Ih so as to heat the data write area 52a to the curie point of the data write area 52a itself or higher, a predetermined current lw (hereinafter referred to write current) is applied to the write line 56 in order to generate the magnetic field B around the write line 56. Preferably, the write current lw applied to the write line 56 is applied to such an extent that the magnetic field B formed in the data write area 52a has an intensity strong enough to change the magnetized state of the heated data write area 52a, which is a paramagnetic state, to the ferromagnetic state. In FIG. 2, reference character Sd denotes the spinning direction of the electrons of the data write area 52a that are arranged by the magnetic field B in the direction of the magnetic field B. Since the spinning direction of the electrons of the data write area 52a is arranged in the direction of the magnetic field B, the magnetized state of the data write area 52a turns into the ferromagnetic state. The spontaneous hall voltage of the data write area 52a is much greater than that when the data write area 52a is in the paramagnetic state. Such an increase in the spontaneous hall voltage of the data write area 52a means that data "1" has been written.

In the method of writing data "0", as shown in FIG. 3, the heating current Ih flows to heat the heating means 50. The heated heating means 50 heats the data write area 52a of the memory layer 52 to a given temperature or higher. This process is the same as when the data "1" is written, except that current is not applied to the write line 56 after the data write area 52a is heated. In other words, a magnetic field is not applied to the heated data write area 52a. Accordingly, the magnetized state of the data write area 52a turns into a state in which the spinning direction of electrons is arranged in arbitrary directions. That is to say, the magnetized state of the data write area 52a turns into the paramagnetic state. The spontaneous hall voltage of the data write area 52a in the paramagnetic state is far less than that in the ferromagnetic state. Such a decrease in the spontaneous hall voltage of the data write area 52a means that data "0" has been written.

In the above-described data recording method, the data "1" can be written in the method of writing data "0" and vice versa. That is, when the data write area 52a has a large spontaneous hall voltage, it can be considered as the case that the data "0" has been written. When the data write area 52a has a small spontaneous hall voltage, it can be considered as the case that the data "1" has been written.

Hereinafter, a method of reading data from the data write area 52a of the MRAM of FIG. 1 will be described. Here, when the data write area 52a has a large spontaneous hall voltage, it is considered as the case that the data "1" has been written. When the data write area 52a has a small spontaneous hall voltage, it can be considered as the case that the data "0" has been written. Alternatively, when the data write area 52a has a large spontaneous hall voltage, it can be considered as the case that the data "0" has been written. When the data write area 52a has a small spontaneous hall voltage, it can be considered as the case that the data "1" has been written.

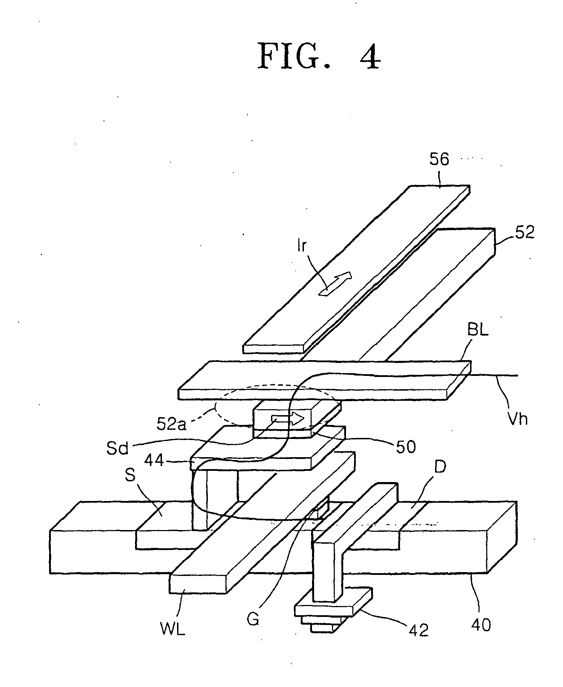

In a method of reading data "1", as shown in FIG. 4, read current Ir is applied to the write line 56, and then the spontaneous hall voltage Vh between the top and bottom of the data write area 52a is measured. Since the spinning direction Sd of the electrons of the data write area 52a is the same as the direction of the magnetic field applied when the data "1" is written, the magnetized state of the data write area 52a is the ferromagnetic state. Accordingly, the spontaneous hall voltage Vh of the data write area 52a is measured to be large.

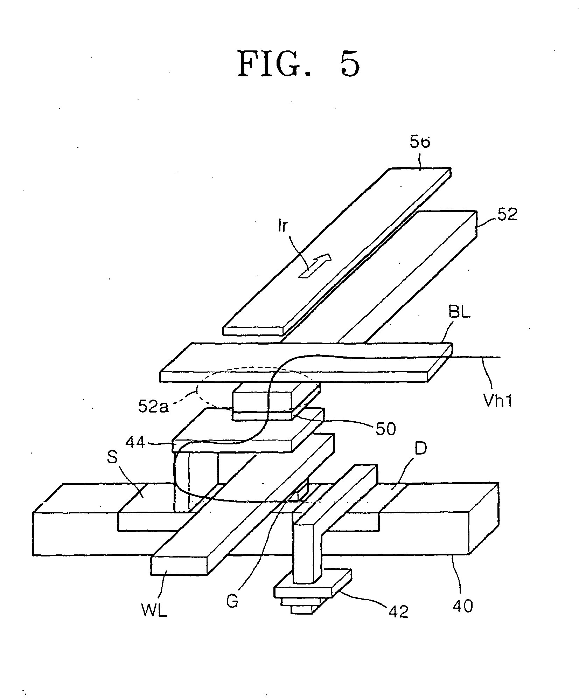

In a method of reading data "0", as shown in FIG. 5, read current Ir is applied to the write line 56, and then the spontaneous hall voltage Vh1 between the top and bottom of the data write area 52a is measured. Here, the electrons of the data write area 52a do not spin in a particular direction, in contrast with the case when data "1" is written. That is, the spinning direction of the electrons of the data write area 52a to which data "0" has been written is in arbitrary directions. Hence, the data write area 52 has no electron spins arranged in a particular direction. Accordingly, the data write area 52a enters into the paramagnetic state. The spontaneous hall voltage Vh1 of the data write area 52a is measured to be much smaller than that when data "1" is read.

While the present invention has been particularly shown and described with reference to preferred embodiments thereof, it will be understood by those of ordinary skill in the art that various changes in form and details may be made therein without departing from the spirit and scope of the present invention as defined by the appended claims. For example, the MOS transistor in the lower structure can be replaced by one of a variety of transistors, and the insulating films in the upper and lower structures can be multi-layered films.

As described above, a MRAM according to the present invention can increase the coercivity caused by highly-integration and improves the thermal security of a cell. The MRAM can operate at an ultra speed because of a small cell resistance. In addition, since the MRAM can be simply manufactured by an existing semiconductor manufacturing process, the manufacturing costs are reduced. Furthermore, since the MRAM writes or reads data using the fact that a spontaneous hall voltage greatly differs according to the magneticization state of a memory layer, it provides a high data sensing margin.

## Claims

1. A magnetic RAM using a spontaneous hall effect, the magnetic RAM comprising:
a heating means (50) connected to the source of a MOS transistor;
a memory layer (52);
a bit line (BL) passing on and being in contact with a portion of the memory layer to which data is written;
**characterised by** an insulating film (54) covering the bit line (BL) and the memory layer (52); and
a write line (56) formed on the insulating film (54) to generate or not a magnetic field necessary for data writing in at least the portion of the memory layer to which data is written;
wherein the heating means (50) is controlled by and formed on the MOS transistor; and
the portion of the memory layer (52) to which data is written being formed on the heating means (50).

2. The magnetic RAM of claim 1, wherein the heating means (50) is provided directly over the gate of the MOS transistor.

3. The magnetic RAM of claim 1 or 2, wherein the heating means (50) is any of an alloy layer containing nickel and chrome and a titanium aluminum nitride (TiAlN) layer that are capable of being heated by current.

4. The magnetic RAM of any preceding claim, wherein the memory layer (52) is an amorphous rare earth (RE)-transition metal (TM) layer.

5. A data writing method of writing a magnetic RAM according to claim 1, comprising:
selecting a memory cell having a memory layer (52) to which data is written; and
writing data by heating the memory layer (52) until the memory layer enters into a paramagnetic state;
**characterised by** heating the memory layer (52) to be in a paramagnetic state; and
changing the paramagnetic state of the memory layer to a ferromagnetic state
by applying a magnetic field to the memory layer depending on data to be written.

6. The data writing method of claim 5, wherein the memory layer (52) is heated by a heating means (50) provided below the memory layer.

7. The data writing method of claim 6, wherein the memory layer (52) is heated by making current flow through the heating means.

8. The data writing method of claim 5, 6 or 7, wherein the memory layer (52) is formed of an amorphous rare earth transition metal (RE-TM).

9. The data writing method of claims 6 or 8, wherein the heating means is any of an alloy layer (50) containing nickel and chrome and a titanium aluminum nitride (TiAlN) layer.

10. A data writing method according to any of claims 5 to 9 wherein the magnetic field is applied by making current flow on and parallel to the memory layer.

11. A data reading method of reading a magnetic RAM according to claim 1, comprising:
selecting a memory cell having a memory layer (52) to which data has been written;
applying read current to the memory layer (52) in the selected memory cell; and
measuring a spontaneous hall voltage of the memory layer (52) to read data from the memory layer.

## Patentansprüche

1. Magnetischer RAM unter Verwendung eines Spontan-Halleffekts,
wobei der magnetische RAM umfasst:
ein Erwärmungsmittel (50), das mit der Source eines MOS-Transistors verbunden ist,
eine Speicherschicht (52),
eine Bitleitung (BL), die auf einem Abschnitt der Speicherschicht verläuft und mit dieser in Kontakt steht, in die Daten geschrieben werden,
**gekennzeichnet durch** einen Isolierfilm (54), der die Bitleitung (BL) und die Speicherschicht (52) bedeckt, und
eine Schreibleitung (56), die auf dem Isolierfilm (54) dazu ausgebildet ist, dass sie ein Magnetfeld, das zum Datenschreiben notwendig ist, in mindestens dem Abschnitt der Speicherschicht, in den Daten geschrieben werden, ausbildet oder nicht ausbildet,
wobei das Erwärmungsmittel (50) vom MOS-Transistor gesteuert und darauf ausgebildet ist und
wobei der Abschnitt der Speicherschicht (52), in den Daten geschrieben werden, auf dem Erwärmungsmittel (50) ausgebildet ist.

2. Magnetischer RAM nach Anspruch 1, wobei das Erwärmungsmittel (50) direkt über dem Gate des MOS-Transistors vorgesehen ist.

3. Magnetischer RAM nach Anspruch 1 oder 2, wobei das Erwärmungsmittel (50) eine Legierungsschicht, die Nickel und Chrom enthält, oder eine Titan-Aluminiumnitrid(TiAlN)-Schicht ist, die in der Lage ist, durch Strom erwärmt zu werden.

4. Magnetischer RAM nach einem der vorhergehenden Ansprüche, wobei die Speicherschicht (52) eine amorphe Seltenerd(SE)-Übergangsmetall(TM)-Schicht ist.

5. Datenschreibverfahren zum Beschreiben eines magnetischen RAM nach Anspruch 1, umfassend:
Auswählen einer Speicherzelle mit einer Speicherschicht (52), in die Daten geschrieben werden, und
Schreiben von Daten durch Erwärmen der Speicherschicht (52), bis die Speicherschicht in einen paramagnetischen Zustand eintritt,
**gekennzeichnet durch** Erwärmen der Speicherschicht (52), so dass sie in einem paramagnetischen Zustand ist, und
Umwandeln des paramagnetischen Zustands der Speicherschicht in einen ferromagnetischen Zustand **durch** Anlegen eines Magnetfelds an die Speicherschicht in Abhängigkeit von den einzuschreibenden Daten.

6. Datenschreibverfahren nach Anspruch 5, wobei die Speicherschicht (52) durch ein Erwärmungsmittel (50) erwärmt wird, das unter der Speicherschicht vorgesehen ist.

7. Datenschreibverfahren nach Anspruch 6, wobei die Speicherschicht (52) **dadurch** erwärmt wird, dass ein Stromfluss durch das Erwärmungsmittel bewirkt wird.

8. Datenschreibverfahren nach Anspruch 5, 6 oder 7, wobei die Speicherschicht (52) aus einer amorphen Seltenerd(SE)-Übergangsmetall(TM)-Schicht gebildet wird.

9. Datenschreibverfahren nach Anspruch 6 oder 8, wobei das Erwärmungsmittel eine Legierungsschicht (50), die Nickel und Chrom enthält, oder eine Titan-Aluminiumnitrid(TiAlN)-Schicht ist.

10. Datenschreibverfahren nach einem der Ansprüche 5 bis 9, wobei das Magnetfeld **dadurch** angelegt wird, dass ein Stromfluss auf der und parallel zur Speicherschicht bewirkt wird.

11. Datenleseverfahren zum Lesen eines magnetischen RAM nach Anspruch 1, umfassend:
Auswählen einer Speicherzelle mit einer Speicherschicht (52), in die Daten geschrieben worden sind,
Anlegen eines Lesestroms an die Speicherschicht (52) der ausgewählten Speicherzelle und
Messen einer Spontan-Hallspannung der Speicherschicht (52) zum Lesen von Daten aus der Speicherschicht.

## Revendications

1. Mémoire vive magnétique utilisant un effet hall spontané, la mémoire vive magnétique comprenant :
des moyens de chauffage (50) connectés à la source d'un transistor MOS ;
une couche de mémoire (52) ;
une ligne de bit (BL) passant sur et étant en contact avec une partie de la couche de mémoire dans laquelle des données sont écrites ;
**caractérisée par** un film isolant (54) couvrant la ligne de bit (BL) et la couche de mémoire (52) ; et
une ligne d'écriture (56) formée sur le film isolant (54) pour générer ou non un champ magnétique nécessaire pour l'écriture de données au moins dans la partie de la couche de mémoire dans laquelle des données sont écrites ;
dans laquelle les moyens de chauffage (50) sont commandés par et formés sur le transistor MOS ; et
la partie de la couche de mémoire (52) dans laquelle des données sont écrites est formée sur les moyens de chauffage (50).

2. Mémoire vive magnétique selon la revendication 1, dans laquelle les moyens de chauffage (50) sont prévus directement sur la grille du transistor MOS.

3. Mémoire vive magnétique selon la revendication 1 ou 2, dans laquelle les moyens de chauffage (50) sont l'une quelconque d'une couche d'alliage contenant du nickel et du chrome et d'une couche de titane-aluminium-nitrure (TiAlN) qui sont capables d'être chauffées par un courant.

4. Mémoire vive magnétique selon l'une quelconque des revendications précédentes, dans laquelle la couche de mémoire (52) est une couche de métal de transition (TM) des terres rares (RE) amorphe.

5. Procédé d'écriture de données pour écrire dans une mémoire vive magnétique selon la revendication 1, comprenant les étapes consistant à :
sélectionner une cellule de mémoire ayant une couche de mémoire (52) sur laquelle des données sont écrites ; et
écrire des données en chauffant la couche de mémoire (52) jusqu'à ce que la couche de mémoire entre dans un état paramagnétique,
**caractérisé par** le chauffage de la couche de mémoire (52) pour qu'elle soit dans un état paramagnétique ; et
changer l'état paramagnétique de la couche de mémoire en un état ferromagnétique en appliquant un champ magnétique à la couche de mémoire en fonction de données devant être écrites.

6. Procédé d'écriture de données selon la revendication 5, dans lequel la couche de mémoire (52) est chauffée par des moyens de chauffage (50) prévus au-dessous de la couche de mémoire.

7. Procédé d'écriture de données selon la revendication 6, dans lequel la couche de mémoire (52) est chauffée en faisant circuler un courant à travers les moyens de chauffage.

8. Procédé d'écriture de données selon la revendication 5, 6 ou 7, dans lequel la couche de mémoire (52) est constituée d'un métal de transition des terres rares (RE-TM) amorphe.

9. Procédé d'écriture de données selon la revendication 6 ou 8, dans lequel les moyens de chauffage sont l'une quelconque d'une couche d'alliage (50) contenant du nickel et du chrome et d'une couche de titane-aluminium-nitrure (TiAlN).

10. Procédé d'écriture de données selon l'une quelconque des revendications 5 à 9, dans lequel le champ magnétique est appliqué en faisant circuler un courant sur et parallèlement à la couche de mémoire.

11. Procédé de lecture de données pour lire une mémoire vive magnétique selon la revendication 1, comprenant les étapes consistant à :
sélectionner une cellule de mémoire ayant une couche de mémoire (52) dans laquelle des données ont été écrites ;
appliquer un courant de lecture à la couche de mémoire (52) dans la cellule de mémoire sélectionnée ; et
mesurer une tension d'effet hall spontanée de la couche de mémoire (52) pour lire des données de la couche de mémoire.
